# EUROPEAN PATENT SPECIFICATION

(11) **EP 2 397 575 B1**
(45) Date of publication and mention of the grant of the patent: **25.03.2015**
(21) Application number: 10741157.1
(22) Date of filing: 29.01.2010
(51) Int. Cl.: C23C 16/458, H01L 21/205

(54) **CVD DEVICE**
CVD-VORRICHTUNG
DISPOSITIF DE DÉPÔT CHIMIQUE EN PHASE VAPEUR (CVD)

(30) Priority: 10.02.2009 JP 2009028065
(43) Date of publication of application: 21.12.2011
(73) Proprietor: Toyo Tanso Co., Ltd., Osaka-shi Osaka 555-0011 (JP)
(72) Inventor: YOSHIMOTO, Yoshiaki, c/o Toyo Tanso Co., Ltd., Kanonji-shi Kagawa 769-1612 (JP)
(74) Representative: Glawe, Delfs, Moll
(86) International application number: PCT/JP2010/051201
(87) International publication number: WO 2010/092878

(56) References cited:
- JP-A- 61 127 696
- JP-A- 2002 249 376
- JP-A- 2008 174 841
- JP-T- 2008 530 370

## Description

### TECHNICAL FIELD

The present invention relates to a CVD apparatus for forming a SiC film on the entire surface of a carbonaceous substrate.

### BACKGROUND ART

A susceptor used for semiconductor epitaxial growth, for example, is made of a material in which a SiC coating layer is formed on a surface of a carbonaceous substrate. The formation of the SiC film on the carbonaceous substrate surface is usually carried out by a CVD (chemical vapor deposition) technique, in which SiC is deposited on the carbonaceous substrate surface directly by causing a halogenated organic silicon compound containing a carbon source, such as hydrocarbon, to undergo a thermal decomposition reaction in a reductive gas flow. The formed SiC film needs to be formed in an extremely dense and uniform layer without any pin hole, in order to cover the entire surface of the carbonaceous substrate.

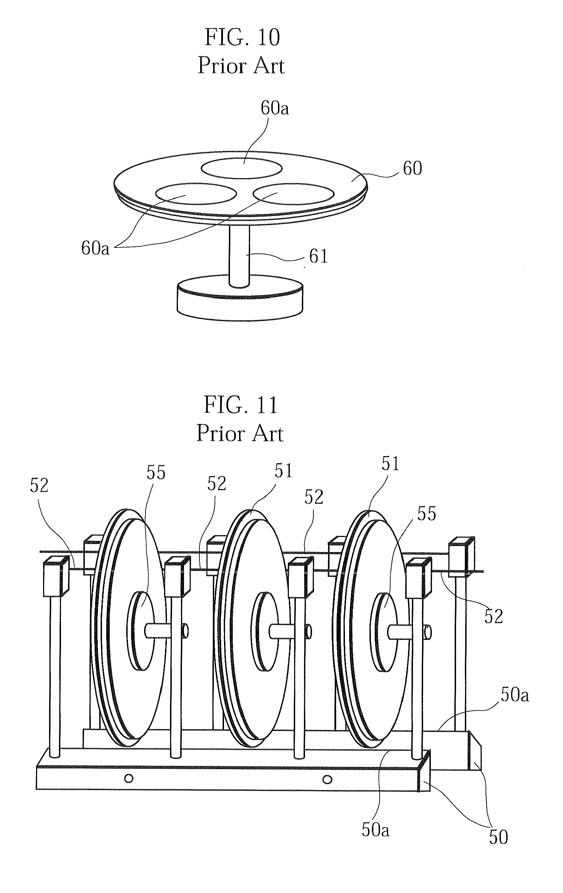

For a susceptor in which a mask portion is provided, the formation of the SiC film has been carried out in such a condition that, as illustrated in Fig. 10 a carbonaceous substrate 60 is oriented horizontally (i.e., laid down horizontally) while supporting the carbonaceous substrate 60 by a masking member 61. This method, however, has the following problems.

When the carbonaceous substrate 60 is oriented horizontally in carrying out the film formation, the SiC film is formed in such a condition that contaminants and peeled fragments exist on the recessed surface 60a of the carbonaceous substrate 60. If the formation of the SiC film is carried out using the susceptor in such a condition, the wafer accommodated in the recess moves within the recessed surface and comes into contact with the side face of the recessed portion due to the adverse effect of the particles. As a consequence, chipping or cracking occurs in the wafer. In the worst case, for example, the problem arises that the wafer comes out of the recess. Another problem has been that color unevenness occurs because of unevenness in the film thickness.

In view of such circumstances, it has been proposed to shift the supporting contact points for the carbonaceous substrate successively by suspending the carbonaceous substrate on a rotation support rod having a cross section smaller than the diameter of the through hole of the carbonaceous substrate (see Patent Document 1 listed below). Such a proposal can solve the foregoing problem. However, the proposal shown in Patent Document 1 can be applied only to the susceptor having a hole. Moreover, it requires an additional drive means, for example, for operating the rotation support rod, leading to other problems such as increase in the production cost of the CVD apparatus and increase in size of the CVD apparatus.

In view of this, a susceptor freestanding-type CVD apparatus as illustrated in Fig. 11 has been proposed. Specifically, in the CVD apparatus, carbonaceous substrates 51 each having the masking member 55 attached thereto are placed on knife-edge portions 50a of tapered-tip support pedestals 50, and opposite surfaces of each carbonaceous substrate 51 are supported by pins 52. Such a structure can be applied to even susceptors with no hole. Moreover, it eliminates the need of drive means for operating the rotation support rod. As a result, it is possible to prevent increase in the production costs of the CVD apparatus and increase in size of the CVD apparatus.

### CITATION LIST

### [PATENT DOCUMENTS]

### [Patent Document 1]

Japanese Published Unexamined Patent Application No. S63(1988)-134663 A

### SUMMARY OF THE INVENTION

### PROBLEMS TO BE SOLVED BY THE INVENTION

However, the above-described conventional structure is such that the opposite surfaces of the carbonaceous substrate 51 are merely supported by the pins 52. As a consequence, the carbonaceous substrate 51 can turn, causing the substrate to shift in a diagonal direction or to even fall over. When the carbonaceous substrate 51 falls over as in the latter case, the problem is not so serious if only one of the carbonaceous substrates 51 has fallen over. However, the falling-over of one of the carbonaceous substrates 51 may cause another carbonaceous substrate 51 adjacent thereto to fall over. As a consequence, a large number of the carbonaceous substrates 51 fall over, making it impossible to form desired SiC films. In addition, since the masking member 55 is merely placed into the recessed portion of the carbonaceous substrate 51, the carbonaceous substrate 51 may fall off when an external force is applied thereto. Moreover, since the support point marks are formed in the outer peripheral portion of the susceptor, cracking can occur in the outer peripheral portion of the susceptor.

Furthermore, the CVD apparatus has such a structure that a SiC film is formed on the carbonaceous substrate 51 while the support pedestal 50 is being rotated. However, the flow quantity and the flow rate of the reacting source gas vary between the central portion and the peripheral portion in the CVD apparatus, because the central portion and the peripheral portion have different distances from the source gas supply unit. Thus, a problem has been that, if the carbonaceous substrates 51 are arrayed in a straight line as in the case of the conventional CVD apparatus, the coating film thickness can vary depending on the arrangement position of the carbonaceous substrate 51, and the amount of warpage in the recessed surface or the recess can become considerably large.

In view of the foregoing circumstances, it is an object of the present invention to provide a CVD apparatus that can remarkably improve the quality and productivity of susceptors without causing increase in the production costs or increase in size of the apparatus.

### MEANS FOR SOLVING THE PROBLEMS

In order to accomplish the foregoing object, the present invention provides a CVD apparatus for forming a SiC film on a surface of a plate-shaped carbonaceous substrate except for a part of the surface of the carbonaceous substrate being covered by a masking jig, by introducing a gas into the apparatus, the carbonaceous substrate having a recessed mask portion formed in a portion of the carbonaceous substrate, and the masking jig being fitted in the mask portion, characterized in that: the masking jig is secured to a film formation jig so that the carbonaceous substrate is supported by the film formation jig; and an upward angle formed by the main surface of the carbonaceous substrate with respect to the vertical axis is set from 1° to 4°.

When the upward angle formed by the main surface of the carbonaceous substrate with respect to the vertical axis is greater than 1° as described above, the area that supports the carbonaceous substrate is large along the horizontal plane direction. Therefore, even if some external force is applied thereto, the masking jig is kept to be fitted into the mask portion of the carbonaceous substrate, so the carbonaceous substrate is prevented from falling off during the formation of the SiC film. Moreover, it is also possible to prevent the falling-off of another carbonaceous substrate adjacent to one of the carbonaceous from, which is caused by the falling-over of the one of the carbonaceous substrates. In addition, since the upward angle of the main surface of the carbonaceous substrate is set to less than 4° with respect to the vertical axis, particles are prevented from building up in the recess. As a result, the wafer is inhibited from chipping or cracking and the wafer is prevented from coming out of the recess when semiconductor epitaxial growth is conducted using the susceptor.

Moreover, this apparatus does not have the structure in which the carbonaceous substrate is supported at its outer periphery. Therefore, the support point marks are not formed in the outer peripheral portion of the susceptor, and as a result, cracking in the outer peripheral portion of the susceptor can be prevented.

Furthermore, the SiC film is not formed in the mask portion covered by the masking jig, while the surface of the carbonaceous substrate except for the mask portion is in a completely exposed condition. Therefore, the surface of the carbonaceous substrate except for the mask portion is coated with the SiC film uniformly. As a result, color uneveness can be prevented.

In addition, the carbonaceous substrate is supported in a vertically oriented condition. Therefore, the susceptor is prevented from warpage resulting from the weight of the carbonaceous substrate itself. Also, the mask portion and the carbonaceous substrate are firmly fixed to each other. Therefore, it is unlikely to form space or cause displacement between the carbonaceous substrate and the jig, so the susceptor does not easily come off.

Accordingly, the susceptor manufactured by the CVD apparatus according to the present invention shows a less amount of warpage and a smaller percentage of occurrence of cracking and color unevenness, resulting in good outer appearance. Thus, the quality of the susceptor can be improved.

Moreover, since the CVD apparatus according to the present invention does not require additional drive means such as the rotation support rod. As a result, the increase in the production costs of CVD apparatus and the increase in size of the CVD apparatus can be prevented.

It is desirable that the angle formed by the carbonaceous substrate with respect to the vertical axis be from 1.5° to 2.5°.

With this structure, the effect of preventing the carbonaceous substrate from falling off during the formation of the SiC film and the effect of inhibiting particles from building up in the recess are exhibited more significantly.

It is desirable that a thermal expansion sheet be disposed between the carbonaceous substrate and the masking jig.

With such a structure, the fitting of the carbonaceous substrate and the masking jig each other are made more firm. As a result, the carbonaceous substrate is prevented from falling off from the masking jig more reliably, and space is prevented from forming between the carbonaceous substrate and the masking jig. Therefore, the gas for forming the film is prevented from coming into the mask portion. Moreover, the SiC film is prevented from peeling from the susceptor when taking the masking jig off from the susceptor after the film formation because the strength of the thermal expansion sheet is less than that of the SiC film.

It is desirable that when forming the SiC film on a surface of each of a plurality of the carbonaceous substrates using a plurality of the film formation jigs, the carbonaceous substrates be disposed so as to be equidistant from the center of the apparatus.

In the CVD apparatus, the central portion of the CVD apparatus and the peripheral portion thereof have different distances from the source gas supply unit. However, when the carbonaceous substrates are disposed so as to be equidistant from the center of the apparatus, the differences in the distances from the source gas supply unit to the carbonaceous substrates, which depend on the arrangement positions of the carbonaceous substrates, are eliminated. Therefore, the amount of warpage can be reduced in every susceptor.

### ADVANTAGES OF THE INVENTION

The present invention exhibits a significant advantageous effect that it can remarkably improve the quality and productivity of susceptors without causing increase in the production costs or increase in size of the apparatus.

### BRIEF DESCRIPTION OF THE DRAWINGS

[Fig. 1] Fig. 1 is a perspective view illustrating the internal structure of a CVD apparatus according to the present invention.
[Fig. 2] Fig. 2 is a plan view illustrating the internal structure of the CVD apparatus according to the present invention.
[Fig. 3] Fig. 3 is a side view illustrating how a carbonaceous substrate is fitted to a film forming jig.
[Fig. 4] Fig. 4 is an exploded view illustrating a primary portion of Fig. 3 enlarged.
[Fig. 5] Fig. 5 shows how the carbonaceous substrate is fitted to the film forming jig, wherein Fig. 5(a) is a perspective view illustrating the state in which a film forming jig, a masking jig, and a carbonaceous substrate are prepared, Fig. 5(b) is a perspective view illustrating how a main portion of the masking jig is fitted into a mask portion (recessed portion) of the carbonaceous substrate, and Fig. 5(c) is a perspective view illustrating how a screw portion of the masking jig is screw-fitted to a screw hole of a MOCVD screw element.
[Fig. 6] Fig. 6 is a side view illustrating a modified example of the CVD apparatus.
[Fig. 7] Fig. 7 is a side view illustrating another modified example of the CVD apparatus.
[Fig. 8] Fig. 8 is a side view illustrating yet another modified example of the CVD apparatus.
[Fig. 9] Fig. 9 shows how semiconductor epitaxial growth is carried out using a susceptor: wherein Fig. 9(a) is an illustrative view showing the case in which there is no particle in the recess; and Fig. 9(b) is an illustrative view showing the case in which particles exist in the recess.
[Fig. 10] Fig. 10 is a perspective view illustrating the internal structure of a conventional CVD apparatus.
[Fig. 11] Fig. 11 is a perspective view illustrating the internal structure of a conventional CVD apparatus.

### BEST MODE FOR CARRYING OUT THE INVENTION

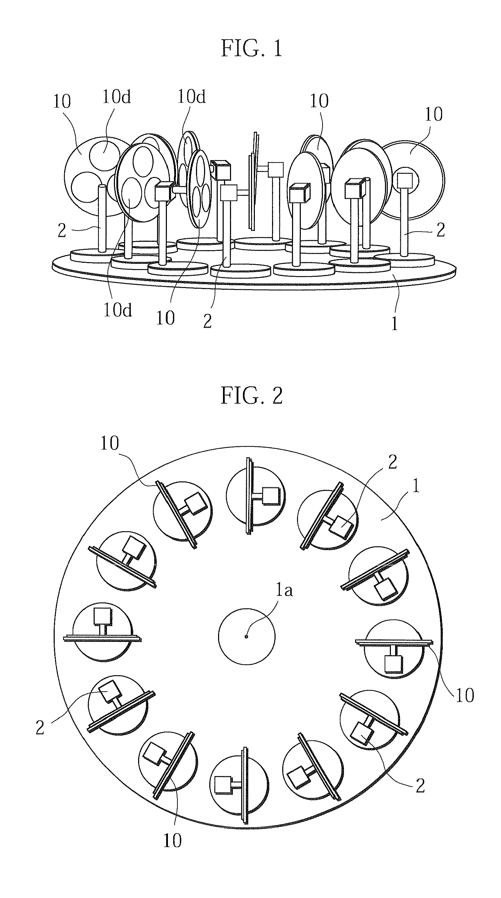

As illustrated in Figs. 1 and 2, a CVD apparatus of the present invention has a disk-shaped rotation table 1 that rotates when forming a SiC film, and a plurality of film formation jigs 2 disposed near the outer periphery of the rotation table 1. It is desirable that these film formation jigs 2 be disposed so as to be equidistant from the center of the apparatus (i.e., the center 1a of the rotation table 1). The reason is as follows. The central portion of the CVD apparatus and the peripheral portion thereof have different distances from the source gas supply unit. However, when the film formation jigs 2 are disposed so as to be equidistant from the center of the apparatus, the carbonaceous substrates 10 that are attached to the film formation jigs 2 are also disposed so as to be equidistant from the center of the apparatus accordingly. Therefore, the differences in the distances from the source gas supply unit to the carbonaceous substrates 10, which depend on the arrangement positions of the carbonaceous substrates, are eliminated, so the amount of warpage can be reduced in every susceptor. Note that reference numeral 10d in Fig. 1 denotes a recess, and the surface in which the recess 10d is formed is the main surface of the carbonaceous substrate 10.

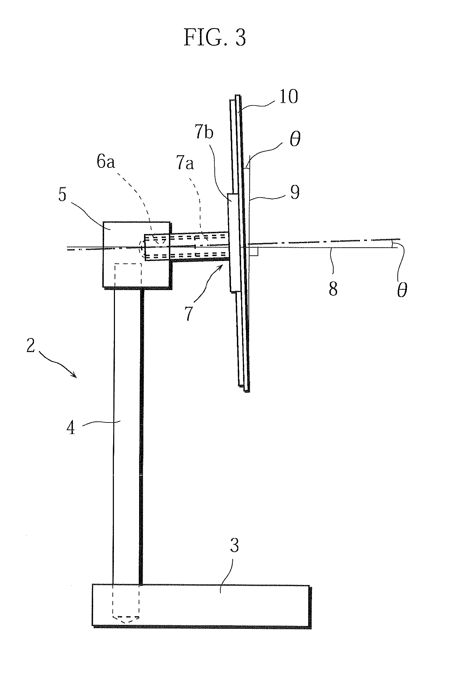

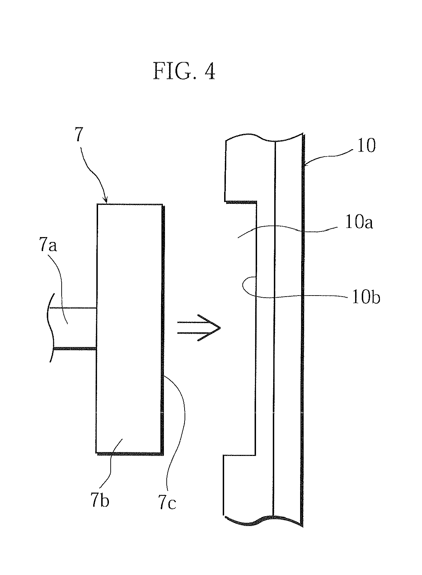

As illustrated in Figs. 3 and 4, each of the film formation jigs 2 comprises a pedestal 3, a support rod 4, a MOCVD cubicle 5, and a MOCVD screw element 6. The support rod 4 is secured near one end of the pedestal 3. The MOCVD cubicle 5 is secured to the other end of the support rod 4. The MOCVD screw element 6 is secured to the MOCVD cubicle 5 so that the MOCVD screw element 6 is inclined at an angle θ (2° in this embodiment) upward with respect to the horizontal axis 8. A screw portion 7a of a masking jig 7 is screw-fitted to a screw hole 6a formed in the circumference of the MOCVD screw element 6, and a plate-shaped main portion 7b is secured to the screw portion 7a. The main portion 7b is fitted to a mask portion (recessed portion) 10a of the carbonaceous substrate 10 so that an abutting surface 7c of the main portion 7b and a bottom face 10b of the mask portion (recessed portion) 10a are in contact with each other, whereby the film formation is inhibited in the mask portion 10a. As illustrated in Fig. 3, the film formation jig 2 can be prevented from falling over during the film formation, for example, when the center of gravity is set to be at substantially the center of the film formation jig 2 with the carbonaceous substrate 10 being mounted thereto.

The main portion 7b is configured to be perpendicular to the screw portion 7a. Therefore, the main surface of the disk-shaped carbonaceous substrate 10 mounted to the main portion 7b is inclined at an angle θ (2° in this embodiment) with respect to the vertical axis 9. Thus, the carbonaceous substrate 10 is mounted to the masking jig 7 so that the main surface of the carbonaceous substrate 10 is inclined slightly upward. Thereby, it is possible to prevent the film formation of the SiC film in the condition in which particles of, for example, contaminants and peeled fragments exist in the recess 10d of the carbonaceous substrate 10, while the carbonaceous substrate 10 is prevented from falling off.

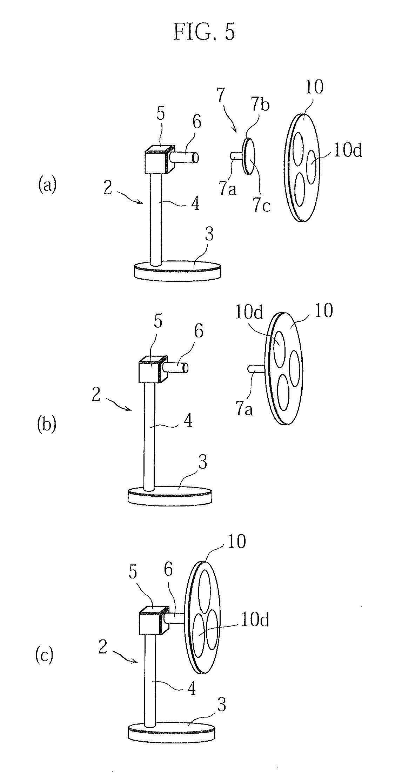

Next, how the carbonaceous substrate 5 is arranged will be described with reference to Figs. 5(a) to 5(c).

First, as illustrated in Fig. 5(a), the film formation jig 2, the masking jig 7, and the carbonaceous substrate 10 are prepared, and thereafter, as illustrated in Fig. 5(b), the main portion 7b of the masking jig 7 is fitted into the mask portion (recessed portion) 10a of the carbonaceous substrate 10. Subsequently, as illustrated in Fig. 5(c), the screw portion 7a of the masking jig 7 is screw-fitted to the screw hole 6a of the MOCVD screw element 6, and thereafter, a large number of the film formation jigs 2 are disposed in the vicinity of the outer periphery of the rotation table 1, whereby the preparation for the film formation is completed.

### (Other Embodiments)

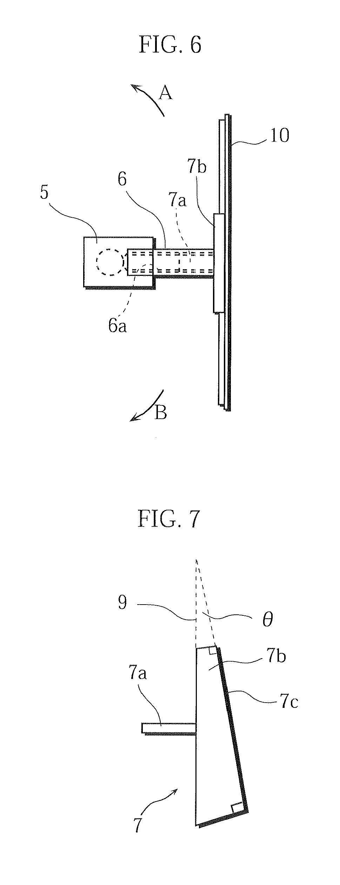

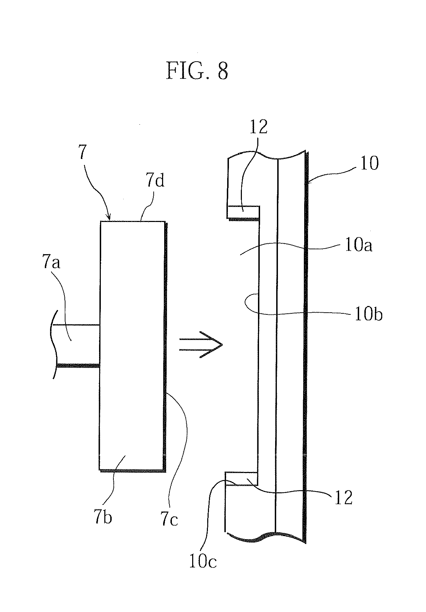

(1) In the foregoing embodiment, the MOCVD screw element 6 is secured so as to be inclined upward by the angle θ with respect to the horizontal axis 8 (in other words, the inclination of the carbonaceous substrate 10 is fixed). However, the MOCVD screw element 6 is not limited to having such a structure, but, as illustrated in Fig. 6, the MOCVD screw element 6 may be configured to be pivotable with respect to the MOCVD cubicle 5 in directions A and B. Such a structure enables the inclination of the carbonaceous substrate 10 to vary depending on the film formation conditions and the like.
(2) The same advantageous effects can be obtained by inclining the abutting surface 7c of the masking jig 7 by the angle θ with respect to the vertical axis 9, as shown in Fig. 7, not by inclining the MOCVD screw element 6 as shown in the foregoing embodiment.
(3) As illustrated in Fig. 8, it is possible to employ the configuration in which a thermal expansion sheet 12 is disposed between the inner circumferential surface 10c of the carbonaceous substrate 10 and the outer circumferential surface 7d of the masking jig 7. Alternatively, the thermal expansion sheet 12 may be wrapped around the outer circumferential portion 7d of the masking jig 7. With such a structure, the fitting of the main portion 7b of the masking jig 7 and the mask portion (recessed portion) 10a of the carbonaceous substrate 10 is made stronger. As a result, the carbonaceous substrate 10 is prevented from falling off from the masking jig 7 more reliably, and moreover, space is prevented from forming between the main portion 7b and the mask portion (recessed portion) 10a. Therefore, the gas for forming the film is prevented from coming into the mask portion (recessed portion) 10a. Moreover, the SiC film is prevented from peeling from the susceptor when taking the masking jig 7 off from the susceptor after the film formation, because the thermal expansion sheet 12 has less strength than the SiC film.

### EXAMPLES

Hereinbelow, the present invention will be described in further detail based on examples thereof. However, the CVD apparatus is not limited by the description of the following examples.

### [Example 1]

A susceptor was fabricated using a CVD apparatus described in the description of the foregoing section BEST MODE FOR CARRYING OUT THE INVENTION.

The susceptor fabricated in this manner is hereinafter referred to as a present invention susceptor A1.

### [Examples 2 to 7]

Susceptors were fabricated in the same manner as described in Example 1 above, except for using CVD apparatuses in which the upward angle θ of the susceptor main surface with respect to the vertical axis 9 was set to 1.0°, 1.5°, 2.5°, 3.0°, 4.0°, and 5.0°, respectively.

The susceptors fabricated in these manners are hereinafter referred to as the present invention susceptors A2 to A7, respectively.

### [Comparative Examples 1 and 2]

Susceptors were fabricated in the same manner as described in Example 1 above, except for using CVD apparatuses in which the upward angle θ of the susceptor main surface with respect to the vertical axis 9 (hereinafter also referred to as the "inclination angle") was set to 0° and 90°, respectively.

The susceptors fabricated in these manners are hereinafter referred to as comparative susceptors Z1 and Z2, respectively.

### [Experiment 1]

The percentage of falling-off of the carbonaceous substrate and the particle deposition region during the fabrication of the susceptors were examined for the present invention susceptors A1 through A7 as well as the comparative susceptors Z1 and Z2. The results are shown in Table 1 below. The experiment conditions (film formation conditions) were as follows.

### - Experiment Conditions

Pressure in the apparatus: 0.1 Torr to 760 Torr
Temperature in the furnace: 1150C° to 1500C°
Introduced gas: CH₃SiCl₃ (methyltrichlorosilan) and hydrogen gas as a carrier gas
Film thickness of the SiC film: 40 µm to 60 µm

**TABLE 1**

| Susceptor | Inclination angle (Degree) | Percentage of carbonaceous substrates that fell off (%) | Region in which particles deposited |
|---|---|---|---|
| Comparative susceptor Z1 | 0 | 92 | Almost no particle observed |
| Present invention susceptor A2 | 1.0 | 65 | Almost no particle observed |
| Present invention susceptor A3 | 1.5 | 14 | Almost no particle observed |
| Present invention susceptor A1 | 2.0 | 0 | Almost no particle observed |
| Present invention susceptor A4 | 2.5 | 0 | Particles of about 50 µm or less were observed in the 1/4 region from the lower edge of the recess |
| Present invention susceptor A5 | 3.0 | 0 | Particles of about 50 µm or less were observed in the 1/3 region from the lower edge of the recess. |
| Present invention susceptor A6 | 4.0 | 0 | Particles of about 50 µm or less were observed in the 1/2 region from the lower edge of the recess |
| Comparative susceptor A7 | 5.0 | 0 | Particles of about 50 µm or less were observed in a region above the 1/2 region from the lower edge of the recess and also in the recessed surface |
| Comparative susceptor Z2 | 90.0 | 0 | A large amount of particles of about 50 µm or less were observed in the recessed surface |

As clearly seen from Table 1, no falling-off of the carbonaceous substrates was observed for the present invention susceptor A1, A4 through A6 and the comparative susceptors A7 and Z2, in which the inclination angle θ was equal to or greater than 2.0°. In contrast, 14% of the carbonaceous substrates fell off for the present invention susceptor A3, in which the inclination angle θ was 1.5°; 65% of the carbonaceous substrates fell off for the present invention susceptor A3, in which the inclination angle θ was 1.0°; and moreover, 92% of the carbonaceous substrates fell off for the comparative susceptor Z1, in which the inclination angle θ is 0°.

On the other hand, almost no particle deposition in the susceptor was observed for the present invention susceptors A1 through A3 and the comparative susceptor Z1, in which the inclination angle θ was equal to or less than 2.0°. In contrast, in the present invention susceptor A4, in which the inclination angle θ is 2.5°, particles with a size of about 50 µm or less were observed in the 1/4 region from the lower edge of the recess; in the present invention susceptor A5, in which the inclination angle θ is 3.0°, particles with a size of about 50 µm or less were observed in the 1/3 region from the lower edge of the recess; and further, in the present invention susceptor A6, in which the inclination angle θ is 4.0°, particles with a size of about 50 µm or less were observed in the 1/2 region from the lower edge of the recess. Further, in the comparative susceptor A7, in which the inclination angle θ is 5.0°, particles with a size of about 50 µm or less were observed in the region above the 1/2 region from the lower edge of the recess, and the particles were also observed even in the recessed surface. Furthermore, in the comparative susceptor Z2, in which the inclination angle θ is 90°, a large amount of particles with a size of about 50 µm or less were observed in the recessed surface.

Taking the foregoing into account, it is necessary that the inclination angle θ be 0° < θ < 90°, preferably 1.0° ≤ θ ≤ 4.0° (especially preferably 1.5° ≤ θ ≤ 2.5°).

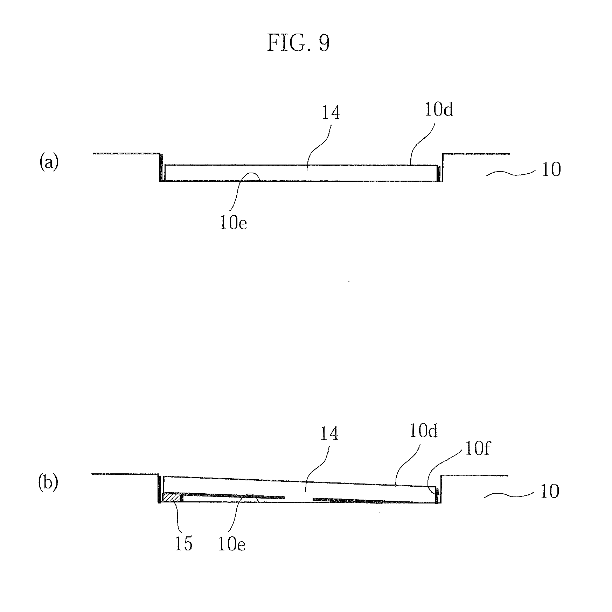

When particles exist in the recessed surface, problems arise that, for example, chipping or cracking occurs in the wafer. The reason will be discussed with reference to Figs. 9(a) and 9(b). As illustrated in Fig. 9(b), when a particle 15 exists in a recessed surface 10e, a wafer 14 may be lifted partially from the recessed surface 10e during mounting of the wafer 14. In such a case, since the processing of the wafer 14 is carried out under high-speed rotation, the wafer 14 can move within the recess 10d and come into contact with a recess side face 10f, causing chipping or cracking in the wafer 14, if the wafer 14 is lifted from the recessed surface 10e. In the worst case, the problem arises that the wafer 14 may come out of the recess 10d, for example. In contrast, the above-described problem is prevented when no particle 15 exists in the recessed surface 10e, as illustrated in Fig. 9(a).

### INDUSTRIAL APPLICABILITY

The CVD apparatus according to the present invention can be used, for example, to manufacture susceptors for semiconductor epitaxial growth.

### DESCRIPTION OF REFERENCE NUMERALS

- 1:: Rotation table
- 2:: Film forming jig
- 6:: MOCVD screw element
- 7:: Masking jig
- 7b:: Main portion
- 8:: Horizontal axis
- 9:: Vertical axis
- 10:: Carbonaceous substrate
- 10a:: Masking portion

## Claims

1. A CVD apparatus for forming a SiC film on a surface of a plate-shaped carbonaceous substrate except for a part of the surface of the carbonaceous substrate being covered by a masking jig, by introducing a gas into the apparatus, the carbonaceous substrate having a recessed mask portion formed in a portion of the carbonaceous substrate, and the masking jig being fitted in the mask portion,
**characterized** in that:
the masking jig is secured to a film formation jig so that the carbonaceous substrate is supported by the film formation jig; and an upward angle formed by the main surface of the carbonaceous substrate with respect to the vertical axis is set from 1° to 4°.

2. The CVD apparatus according to claim 1, wherein the upward angle formed by the main surface of the carbonaceous substrate with respect to the vertical axis is from 1.5° to 2.5°.

3. The CVD apparatus according to claim 1 or 2, wherein a thermal expansion sheet is disposed between the carbonaceous substrate and the masking jig.

4. The CVD apparatus according to any one of claims 1 through 3, wherein, when forming the SiC film on the surface of each of a plurality of the carbonaceous substrates using a plurality of film formation jigs, the carbonaceous substrates are disposed so as to be equidistant from the center of the apparatus.

## Patentansprüche

1. CVD Vorrichtung zum Bilden eines SiC-Films auf einer Oberfläche eines plattenförmigen kohlenstoffhaltigen Substrats mit Ausnahme eines Teils der Oberfläche des kohlenstoffhaltigen Substrats, der durch eine Maskierungsschablone abgedeckt ist, durch Einbringen eines Gases in die Vorrichtung, wobei das kohlenstoffhaltige Substrat einen rückspringenden Maskenteil aufweist, der in einem Teil des kohlenstoffhaltigen Substrates ausgebildet ist und die Maskierungsschablone in den Maskenteil eingepasst ist, dadurch **gekennzeichnet**, dass:
die Maskierungsschablone an einer Filmbildungsschablone derart angebracht ist, dass das kohlenstoffhaltige Substrat durch die Filmbildungsschablone getragen wird und ein Aufwärtswinkel, der durch die Hauptfläche des kohlenstoffhaltigen Substrats mit Bezug auf die Vertikalachse gebildet wird, von 1° bis 4° eingestellt ist.

2. CVD Vorrichtung nach Anspruch 1, wobei der Aufwärtswinkel, der durch die Hauptfläche des kohlenstoffhaltigen Substrats mit Bezug auf die Vertikalachse gebildet wird, zwischen 1,5° bis 2,5° beträgt.

3. CVD Vorrichtung nach Anspruch 1 oder 2, wobei ein Thermalexpansionsfilm zwischen dem kohlenstoffhaltigen Substrat und der Maskierungsschablone angeordnet ist.

4. CVD Vorrichtung nach einem der Ansprüche 1 bis 3, wobei, bei der Ausbildung des SiC-Films auf der Oberfläche jedes einer Anzahl von kohlenstoffhaltigen Substraten unter Verwendung einer Anzahl von Filmbildungsschablonen die kohlenstoffhaltigen Substrate so angeordnet sind, dass sie äquidistant von der Mitte des Apparates sind.

## Revendications

1. Appareil CVD pour former un film de SiC sur une surface d'un substrat carboné en forme de plaque à l'exception d'une partie de la surface du substrat carboné étant recouverte par un gabarit de masquage, par introduction d'un gaz dans l'appareil, le substrat carboné ayant une partie de masque évidée formée dans une partie du substrat carboné, et le gabarit de masquage étant ajusté dans la partie de masque, **caractérisé en ce que** :
le gabarit de masquage est fixé à un gabarit de formation de film de sorte que le substrat carboné soit soutenu par le gabarit de formation de film ; et un angle vers le haut formé par la surface principale du substrat carboné par rapport à l'axe vertical est défini de 1° à 4°.

2. Appareil CVD selon la revendication 1, dans lequel l'angle vers le haut formé par la surface principale du substrat carboné par rapport à l'axe vertical est de 1,5° à 2,5°.

3. Appareil CVD selon la revendication 1 ou 2, dans lequel une couche de dilatation thermique est disposée entre le substrat carboné et le gabarit de masquage.

4. Appareil CVD selon l'une quelconque des revendications 1 à 3, dans lequel, lors de la formation du film de SiC sur la surface de chacun d'une pluralité de substrats carbonés au moyen d'une pluralité de gabarits de formation de film, les substrats carbonés sont disposés de manière à être équidistants par rapport au centre de l'appareil.
